# EUROPEAN PATENT APPLICATION

(11) **EP 4 608 086 A1**
(43) Date of publication of application: **27.08.2025**
(21) Application number: 25156828.3
(22) Date of filing: 10.02.2025
(51) Int. Cl.: H10D 8/60, H10D 8/01, H10D 62/10, H10D 62/832

(54) **METHOD FOR REGULATING THE SCHOTTKY BARRIER HEIGHT IN A SILICON CARBIDE POWER DIODE, AND POWER DIODE**

(30) Priority: 23.02.2024 IT 202400003835
(71) Applicant: STMicroelectronics International N.V., 1228 Plan-les-Ouates, Geneva (CH); Consiglio Nazionale Delle Ricerche, 00185 Roma (IT)
(72) Inventor: RASCUNA', Simone, 95129 CATANIA (IT); BELLOCCHI, Gabriele, 95124 CATANIA (IT); ROCCAFORTE, Fabrizio, 95030 MASCALUCIA (CT) (IT)
(74) Representative: Studio Torta S.p.A.

(57) **Abstract**

Electronic device (100), comprising: a body (101) of semiconductor material having a surface (103) and an N-type electrical conductivity; switching regions (102) of a P-type electrical conductivity, the switching regions extending into the body (101) starting from the surface; surface portions (104) having the P-type electrical conductivity, extending at the surface (103) between said switching regions (102); ohmic contact regions (129) at the switching regions (102); and a contact metal layer (110) above the surface and in direct electrical contact with the surface portions (104) and the ohmic contact regions (129).

## Description

The present invention relates to an electronic device and a manufacturing process of the electronic device, in particular to a method for regulating the Schottky barrier height in a silicon carbide power diode, and to the power diode thereof.

Electronic devices called JBS (Junction Barrier Schottky) or MPS (Merged PiN Schottky) diodes are known. Such devices are generally made in silicon carbide (SiC) substrates and comprise implanted zones having opposite conductivity to that of the substrate (e.g. of P-type, for N-type substrate). In these devices, two types of distinct contacts are present: an ohmic contact at the implanted zones and a Schottky contact in the areas comprised between the implanted zones.

These features make JBS diodes particularly suitable for working in high-voltage power devices.

Nowadays, minimizing conduction losses in discrete power devices is a key requirement to reduce the overall energy consumption of modern power circuits and modules. For this reason, the possibility of controlling the Schottky Barrier Height (SBH) value is a very important aspect for adapting the voltage drop of Schottky diodes. Lowering the SBH produces a significant reduction in voltage drop. Lowering the SBH entails, as a negative effect, strongly increasing the leakage current in reverse mode.

A need is therefore felt for JBS diodes with high efficiency in forward bias without the drawback of high loss in reverse mode or reverse bias.

The aim of the present invention is to provide a device and a manufacturing method which overcome the drawbacks of the prior art and which meet the above-mentioned needs.

According to the present invention, an electronic device and a manufacturing process of the electronic device are provided, as defined in the attached claims.

For a better understanding of the present invention, preferred embodiments thereof are now described, purely by way of non-limiting example, with reference to the attached drawings, wherein:
- Figure 1 shows a cross-section of the principle physical structure of a semiconductor device including a JBS diode;
- Figures 2A-2F show cross-sections through a die of semiconductor material in subsequent manufacturing steps of the JBS diode of Figure 1; and
- Figures 3A and 3B show variations of the steps of the manufacturing process shown in Figures 2A and 2B.

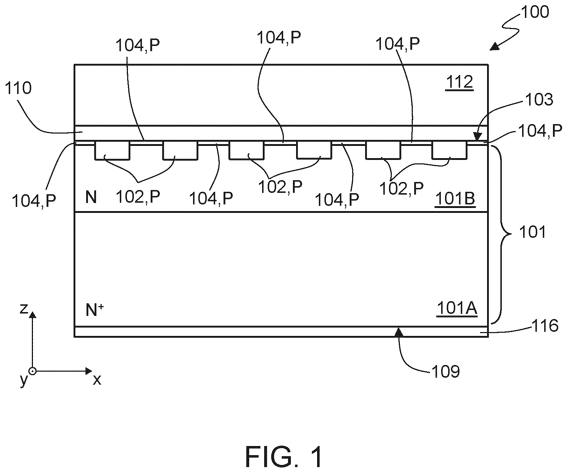

Figure 1 shows an embodiment of an electronic device 100 in a triaxial system of axes X, Y, Z orthogonal to each other. The electronic device 100 forms a JBS ("Junction Barrier Schottky") diode or MPS ("Merged-PiN-Schottky") diode, and in general may be part of an integrated device comprising other electronic components, not shown. Accordingly, the electronic device 100 is generally formed in an active area, for example delimited externally by oxide field regions or edge termination region or edge protection ring (e.g. a P-type implanted region), in a per se known manner.

The electronic device 100 comprises a substrate 101 of silicon carbide (SiC), in particular 4H-SiC, having N-type electrical conductivity. The substrate 101 is formed by a substrate 101A of N+ type having low resistivity and an epitaxial layer 101B of N-type. For example, the substrate 101A has a thickness comprised between 40 and 500 pm, typically 180 µm, and a resistivity comprised between 10 and 30 mΩ·cm, typically 20 mΩ·cm; the epitaxial layer 101B has a thickness comprised between 3 and 15 µm and a doping comprised between 10¹⁵ and 5×10¹⁶. Dopings up to 10¹⁷ are possible. The substrate 101A and the epitaxial layer 101B may have thickness and conductivity different from what has been indicated above, according to manufacturing and application needs. The body 101 has a first (front) surface 103 and a second (back) surface 109. Implanted regions 102 of P-type, mutually spaced, extend inside the epitaxial layer 101B starting from the first surface 103. The implanted regions 102 may extend longitudinally in a direction perpendicular to the plane of the drawing, in the form of strips, or may extend along the sides of regular or irregular geometric figures.

According to the present invention, the upper portion of the epitaxial layer 101B has a surface layer 104 of P-type. For example, the surface layer 104 may have a doping level comprised between 10¹¹ and 10¹⁴ at/cm³. The depth of the surface layer 104 is lower than that of the implanted regions 102; for example the depth of the surface layer 104 is of 0.1 µm and the depth of the implanted regions 102 is generally comprised between 0.4 and 0.8 pm, for example of about 0.5 µm. A depth of the implanted regions 102 up to 2 µm is also envisaged according to an embodiment wherein the implantation occurs by exploiting the channeling effect. The depths are here considered parallel to the Z axis, starting from the surface 103 towards the surface 109.

A first metal layer 110, extends over the first surface 103 of the body 101. The first metal layer 110 forms, at the areas of the epitaxial layer 101B between the implanted regions 102 (i.e., at the regions 104), Schottky contacts or Schottky diodes. The first metal layer 110 forms, at the implanted regions 102, JB diodes. The region of the device 100 that includes the JB elements and the Schottky diodes is an active area of the device 100.

The first metal layer 110 may for example have a thickness comprised between 50 and 400 nm, in particular between 200 and 400 nm. The first metals layer 110 is of a material that allows a Schottky contact to be formed comprised between 0.7 and 1.2 eV, e.g. of about 0.9 eV. For example, the first metal layer 110 is of TiN. Other materials for the first metal layer 110 include, for example: Mo, MoN, WN, WC, Ta, TaN.

A second metal layer 112, that is thicker, extends above the first metal layer 110. The second metal layer 112 is for example of an alloy including Aluminum (Al), for example AlSiCu, and has for example a thickness comprised between 2 and 10 µm (typically of about 5 pm).

Furthermore, a back contact metal layer 116 extends onto the second surface 109 of the body 101.

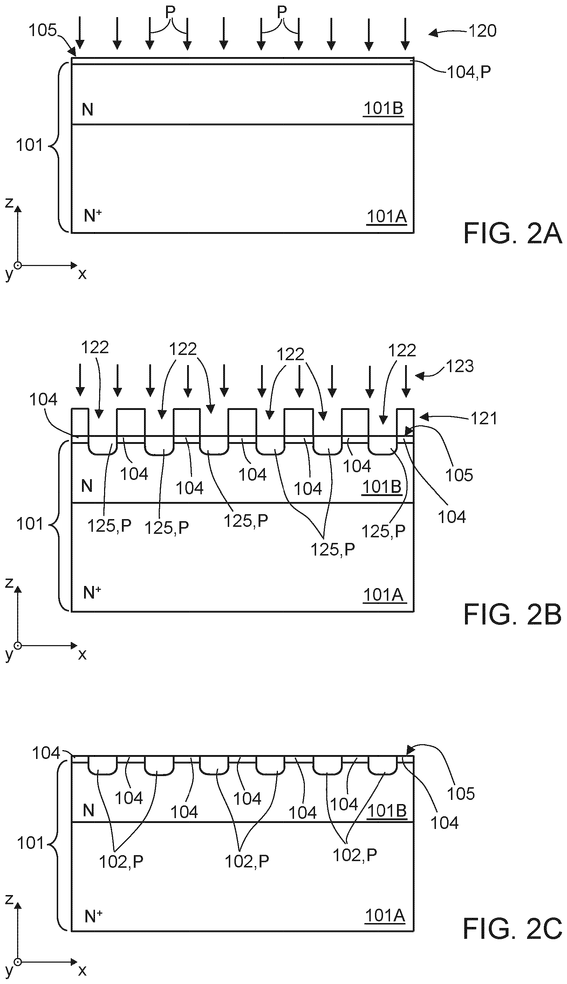

The electronic device 100 of Figure 1 may be implemented in the manner described hereinbelow, with reference to Figures 2A-2F.

Initially, Figure 2A, the epitaxial layer 101B, having an upper surface 105, is subject to a step of regulating the surface conductivity. For this purpose, a blanket ("unmasked") surface implant is performed, represented in Figure 2A by arrows 120. According to the invention, doping atoms are introduced for generating a layer with P-type electrical conductivity, for example atoms of boron or aluminum, at a dose comprised between 10¹² and 10¹⁵ at/cm² (boundaries included) and implant energy comprised between 10 keV and 200 keV (boundaries included). The surface layer 104 is thus formed, with P-type conductivity.

Thereafter, Figure 2B, a hard mask 121 having windows 122 is formed on the upper surface 105 of the body 101. Using the windows 122, a P-type implant is performed, represented schematically by arrows 123, for example of atoms of Aluminum or Boron at a dose of 10¹² at/cm² and with implant energy in the range 10-50 keV. P-type regions 125 are thus formed. In general, the process parameters are optimized so that the depth of the implanted regions 102 is greater than that of the surface layer 104, as indicated.

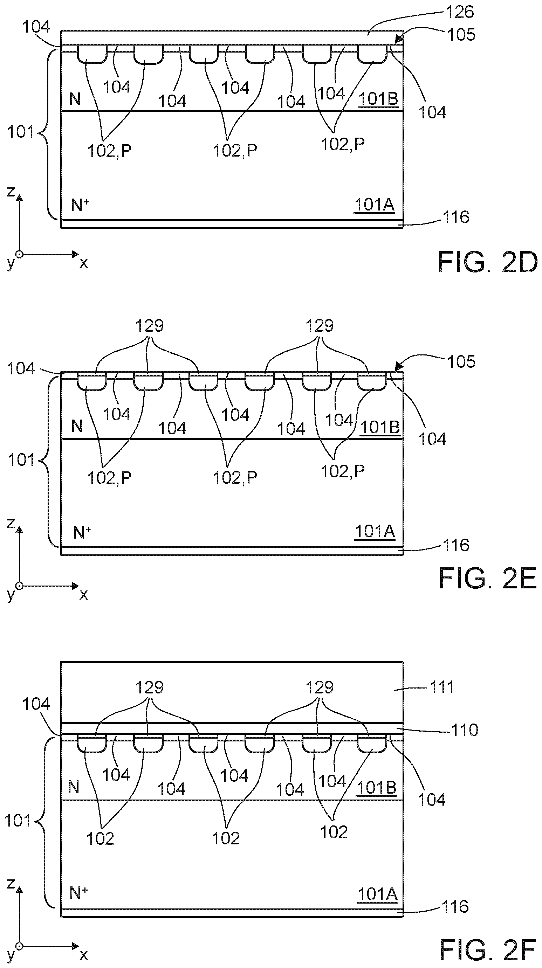

Then, Figure 2C, the hard mask 121 is removed and a thermal process of activation of the implanted ions is performed. The process is performed at a temperature higher than 1500°C (e.g., 1600°C) and allows the activation of the implanted regions 102 of Figure 2.

Subsequently, Figure 2D, the upper surface 105 is covered by a masking layer 126 and a back metal layer is deposited on the second surface 109 of the body 101 to form the back contact metal layer 116. This step may comprise the formation of a rear ohmic contact (optional).

After removing the masking layer 126 from the upper surface 105 of the body 101, Figure 2E, further steps are performed for forming ohmic contacts 129 on the front of the device, including forming nickel regions exclusively at the implanted regions 102, in particular using a silicon oxide mask to cover regions of the surface 105 different from the implanted regions 102. A subsequent high-temperature thermal annealing (between 900°C and 1000°C for a time interval from 1 minute to 120 minutes), allows ohmic contacts 129 of nickel silicide Ni₂Si to be formed, by chemical reaction between the deposited nickel and the silicon of the substrate 101 (more in particular, of the epitaxial layer 101B). Nickel in contact with the mask oxide does not react. Subsequently, a step of removing the unreacted metal and the mask is performed. Other modes of forming ohmic contacts are possible as an alternative to what has been described. For example, the ohmic contacts 129 may be formed by heating the implanted regions 125 using a LASER source, according to the teaching of patent application EP3896719A1.

Then, Figure 2F, a front contact metal layer (first metal layer 110), for example of TiN (alternatively, of one of Mo, MoN, WN, WC, Ta, TaN) is deposited above the surface 105 and the ohmic contacts 129. The first metal layer 110 forms a continuous layer. As mentioned, the first metal layer 110 is configured to form, with the implanted layer 104, a Schottky contact with a barrier height equal to, for example, 0.9 eV.

Finally, the second metal layer 111 is deposited above the first metal layer 110. The deposition of the first and the second metal layers 110, 111 occurs for example by a sputtering technique.

In a manner not illustrated in the Figures, a passivation layer is also formed on the second metal layer 111, to protect the latter. The passivation layer includes openings or windows that expose selective portions of the second metal layer 111, for electrically contacting it.

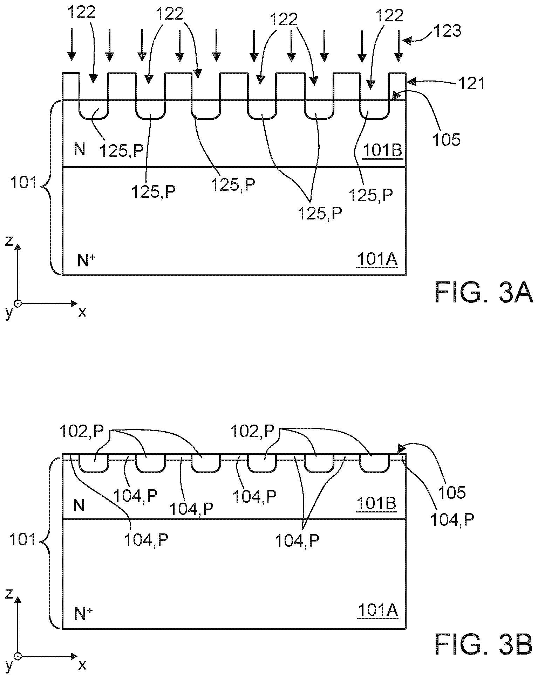

According to a variant shown in Figures 3A and 3B, the implant step of the P-type regions 125 occurs before the implant step of the surface layer 104 of P-type. For this purpose, initially, Figure 3A, the hard mask 121 having windows 122 is formed on the upper surface 105 of the epitaxial layer 101B. Using the windows 122, the P-type regions 125 are implanted, as represented schematically by the arrows 123.

After removing the hard mask 121, Figure 3B, the blanket ("unmasked") implant step is performed for modifying the conductivity of the surface zone of the epitaxial layer 101B, lateral to the implanted regions 125. For this purpose, P-type doping ions are implanted in the epitaxial layer 101B in proximity to its upper surface 105 (as represented schematically by the arrows 120), thus forming the surface layer 104. An activation step of the dopants at a temperature higher than 1500°C then follows. The device is completed according to the steps already described with reference to Figures 2C-2E.

The electronic device 100 described has numerous advantages.

In particular, the present invention allows reducing losses in reverse bias with a minimum increase in SBH.

Finally, it is clear that modifications and variations may be made to the device and manufacturing process described and illustrated herein without thereby departing from the scope of the present invention, as defined in the attached claims.

Furthermore, the material of the substrate 101 may be one of 4H-SiC, 6H-SiC, 3C-SiC, 15R-SiC. Alternatively, it may be Silicon or another semiconductor material.

The electronic device 100 may alternatively be one of: a Merged-PiN-Schottky (MPS) diode, a Schottky Diode, a JBS Diode, a MOSFET, an IGBT, a JFET, a DMOS.

## Claims

1. An electronic device (100), comprising:
a body (101) of semiconductor material having a surface (103) and an N-type electrical conductivity;
switching regions (102) having a P-type electrical conductivity, the switching regions extending into the body (101) starting from the surface; and
ohmic contact regions (129) at the switching regions (102),
**characterized in that** it further comprises:
surface portions (104) having P-type electrical conductivity, extending at the surface (103) of the body (101) at least between said switching regions (102); and
a metal layer (110) above the surface (103) of the body (101), the metal layer (110) being in electrical contact with the body (101) through said surface portions (104) and in electrical contact with the switching regions (102) through the ohmic contact regions (129).

2. The electronic device according to claim 1, wherein the surface portions (104) extend with electrical continuity along the entire surface (103).

3. The electronic device according to claim 1 or 2, wherein the surface portions (104) are in direct electrical contact with said switching regions (102).

4. The electronic device according to any of the preceding claims, wherein the contact metal layer (110) is in direct electrical contact with the surface portions (104).

5. The electronic device according to any of the preceding claims, wherein the metal layer (110) is of a metal for forming, with the surface portions (104), a Schottky contact having a barrier height comprised between 0.7 and 1.2 eV, in particular equal to 0.9 eV.

6. The electronic device according to any of the preceding claims, wherein the contact metal layer (110) is one of: TiN, Mo, MoN, WN, WC, Ta, TaN.

7. The electronic device according to any of the preceding claims, wherein the body (101) is of silicon carbide, SiC.

8. The electronic device according to any of the preceding claims, wherein the body (101) comprises an epitaxial layer (101B) on a substrate (101A), said surface (103) belonging to the epitaxial layer (101B), the surface portions (104) having, in the epitaxial layer starting from the surface (103), a depth smaller than the depth of the switching regions (102).

9. The electronic device according to any of the preceding claims, wherein the surface portions (104) have a P-type doping value comprised between 10¹¹ and 10¹⁴ at/cm³.

10. The electronic device according to one of the preceding claims, forming a junction barrier Schottky, JBS, diode or a Merged-PiN-Schottky, MPS, diode.

11. A process for manufacturing an electronic device, comprising the steps of:
in a solid body (101) of semiconductor material having a surface (105) and an N-type electrical conductivity, forming switching regions (102), having a P-type electrical conductivity, extending into the body starting from the surface (105) and delimiting between each other regions of the surface (103) of the solid body;
forming a surface layer (104), having a P-type electrical conductivity, extending at the surface (103) at least between said switching regions (102);
forming ohmic contact regions (129) at the switching regions (102); and
forming a metal layer above the surface (103) and in electrical contact with the ohmic contact regions (129) and the surface portions (104).

12. The process according to claim 11, wherein the surface layer (104) extends with electrical continuity along the surface (103).

13. The process according to claim 11 or 12, wherein the surface layer (104) and said switching regions (102) are formed in mutual electrical contact.

14. The process according to any of claims 11-13, wherein the metal layer (110) is formed in direct electrical contact with the surface portions (104).

15. The process according to any of claims 11-14, wherein the metal layer (110) is of a metal for forming, with the surface layer (104), a Schottky contact having a barrier height comprised between 0.7 and 1.2 eV, in particular equal to 0.9 eV, said metal layer (110) being in particular of a material from among: TiN, Mo, MoN, WN, WC, Ta, TaN.

16. The process according to any of claims 11-15, wherein the surface layer (104) is formed through implant of P-type doping species with an implant dose comprised between 10¹² and 10¹⁵ at/cm².
